(19) Europäisches Patentamt
European Patent Office
Office européen des brevets

(11) EP 4 341 204 B1

(12) **EUROPEAN PATENT SPECIFICATION**

(45) Date of publication and mention of the grant of the patent:
**10.12.2025 Bulletin 2025/50**

(21) Application number: **22732611.3**

(22) Date of filing: **17.05.2022**

(51) International Patent Classification (IPC):
***B81C 1/00*** *(2006.01)*

(52) Cooperative Patent Classification (CPC):
**B81C 1/00476; B81C 1/00857;** B81C 2201/0132

(86) International application number:
**PCT/GB2022/051233**

(87) International publication number:
**WO 2022/243667 (24.11.2022 Gazette 2022/47)**

(54) **METHOD OF MANUFACTURING A MICROSTRUCTURE**

VERFAHREN ZUR HERSTELLUNG EINER MIKROSTRUKTUR

PROCÉDÉ DE FABRICATION D’UNE MICROSTRUCTURE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.05.2021 GB 202107171**

(43) Date of publication of application:
**27.03.2024 Bulletin 2024/13**

(73) Proprietor: **Memsstar Limited**
**Kirkton Campus**
**Livingston**
**Lothian EH54 7BN (GB)**

(72) Inventor: **O’HARA, Anthony**
**Livingston West Lothian EH54 7BN (GB)**

(74) Representative: **Lincoln IP**
**4 Rubislaw Place**
**Aberdeen AB10 1XN (GB)**

(56) References cited:
**US-A1- 2012 107 993**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

The present invention relates to a method for use in the manufacturing of microstructures. Typically, the microstructures are in the form of micro electromechanical systems (MEMS) that require the removal of a material relative to a substrate or other deposited material. In particular, this invention relates to an improved method for manufacturing a microstructure that employs the step of etching a silicon dioxide sacrificial layer with a hydrogen fluoride (HF) vapour.

### Background to the Invention

Many materials are known to be employed during the manufacture of microstructures e.g. silicon, silicon dioxide ($SiO_2$), silicon nitride ($Si_3N_4$), aluminium and photoresist to name but a few. Some of these materials are employed as a sacrificial material while others are employed to define and hence form the microstructure. It is not uncommon during the manufacture of a microstructure for more than one sacrificial etch step to be employed. For example, a film may initially be employed as a mask during a first sacrificial etch process and then be subsequently etched as the next sacrificial layer. In any release etch it is therefore highly desirable for there to be a high etch selectivity between the sacrificial layer and the surrounding materials.

During the manufacture of a microelectro-mechanical structures (MEMS) 1, of the type presented in Figure 1, a sacrificial layer 2 and a structure defining layer 3 are initially deposited on a substrate 4. An etching processes is then employed to remove the sacrificial (i.e. unwanted) areas or layers 2 of material.

One of the most common materials used as the sacrificial layer 2 is silicon dioxide that is then etched using a hydrogen fluoride (HF) vapour, see for example UK patent number GB 2,487,716 B. An HF vapour etch is a plasma-less chemical etch and is described by the reaction equations:

$$2HF + H_2O \rightarrow HF_2^- + H_3O^+ \qquad (1)$$

$$SiO_2 + 2HF_2^- \rightarrow SiF_4 + 4H_2O \qquad (2)$$

The water ($H_2O$) is found to ionises the HF vapour, as described by equation (1), and the ionised HF vapour ( $HF_2^-$ ) then etches the silicon dioxide ($SiO_2$), with the water ($H_2O$) acting as a catalyst. From equation (2), it is clear that water ($H_2O$) is also generated from the etching reaction itself.

The hydrogen fluoride (HF) vapour etching of silicon dioxide 2 is known to exhibit high selectivity to many common structure defining layers 3. For example, the theoretical selectivity to silicon and aluminium is high and no etching or corrosion is expected. Silicon nitride ($Si_3N_4$) is another material often employed as a mask or structure defining layer 3 within the production process of a MEMS 1, even although its selectivity with silicon dioxide 2 is not as high as that exhibited by silicon and aluminium.

As well as being employed in the production of MEMS 1, silicon dioxide 2 and silicon nitride 3 layers are also present within semiconductor devices. Therefore, it is also known for hydrogen fluoride (HF) vapour etching techniques to be employed to create air-gap structures in multi-level metal structures used in standard semiconductor devices, see for example US patent number US 7,211,496.

It is universally accepted that for HF vapour etching to proceed, with a usable etch rate, say greater than 30 nm/min, a condensed fluid layer 5 is required to be present on the surface to be etched, see for example Journal of Vacuum Science and Technology A, 10 (4) July/Aug 1992 entitled "Mechanisms of the HF/H2O vapor phase etching of SiO2" in the name of Helms et al. Of all the compounds associated with the above described HF vapour etching process, water ($H_2O$) has the lowest vapour pressure and therefore forms the basis of the condensed fluid layer 5. European patent number EP2046677 B1 discloses how control of the formation and composition of the condensed fluid layer 5 is key to managing the HF vapour etching of silicon dioxide. Precise etch control is achieved by performing the HF etch in a vacuum chamber, controlling the chamber pressure, temperature and the gas flows into the chamber. Other parameters that influence the HF vapour etch are the composition of the silicon dioxide layer being etched and the method of its deposition.

Chemical vapour deposition (CVD) processes are normally employed to deposit the silicon dioxide ($SiO_2$) 2 and silicon nitride ($Si_3N_4$) layers 3 onto the substrate 4. In these processes, chemical precursors, one a silicon source and the other an oxygen or nitrogen source, react to deposit the silicon dioxide layer 2 or silicon nitride layer 3 onto the substrate 4.

The most common of these processes is Plasma Enhanced CVD (PECVD) since this process allows the deposition to be performed at a low temperature, < 450 °C.

When depositing a silicon nitride layer 3 it is known in the art to make such layers silicon rich as this assists in increasing the selectivity with a sacrificial silicon dioxide layer 2. Even with such levels of increased selectivity, the HF vapour etching process is still found to etch the silicon nitride layer 3, albeit at a much lower rate than the silicon dioxide layer 2. It is known that the HF etching of the silicon nitride layer 3 can result in a solid residual layer comprising ammonium salt being left on the MEMS 1. Any such solid residue formed in this way is obviously highly undesirable in the production of a MEMS or semiconductor microstructure.

An example of a method known in the art is disclosed in US patent publication number US2012/0107992 A1.

## Summary of the Invention

According to a first aspect of the present invention, there is provided a method of producing a microstructure that comprises silicon rich silicon nitride ($Si_3N_4$), the method comprising:

- employing a hydrogen fluoride (HF) vapour to etch a sacrificial layer of silicon dioxide ($SiO_2$) wherein the HF vapour also etches the silicon rich silicon nitride ($Si_3N_4$); and characterised by
- once the HF vapour etch is complete, subsequently removing a solid silicon residue formed by the HF vapour etch.

The vapour etching of the sacrificial layer of silicon dioxide ($SiO_2$) and the removal of the solid silicon residue may be performed sequentially within separate processing chambers.

Optionally, removing the solid silicon residue comprises reacting the solid silicon residue with a first additional gas.

Optionally, removing the solid silicon residue comprises reacting the solid silicon residue with a hydrogen gas or hydrogen compound to produce silane ($SiH_4$).

Alternatively, removing the solid silicon residue may comprise reacting the solid silicon with an oxygen gas or oxygen compound to produce silicon dioxide ($SiO_2$). Removing the solid silicon residue may then further comprise employing a hydrogen fluoride (HF) vapour to etch the silicon dioxide ($SiO_2$).

In a further alternative, removing the solid silicon residue comprises reacting the solid silicon residue with a fluorine gas or fluorine compound to produce silicon tetrafluoride ($SiF_4$).

In a further alternative, removing the residue may comprise etching the solid silicon with a Xenon Difluoride ($XeF_2$) vapour.

The method of producing a microstructure may further comprises employing a vacuum pumping system to remove by products formed when removing the solid silicon residue. Most preferably the microstructure comprises a micro electromechanical systems (MEMS). Alternatively, the microstructure comprises a semiconductor device.

## Brief Description of the Drawings

There will now be described, by way of example only, various embodiments which are examples given as an aid for understanding the invention with reference to the drawings, of which:

Figure 1 presents a schematic representation of an HF vapour etch of a MEMS that comprises a silicon dioxide layer located between a substrate and a structure defining layer;

Figure 2 presents a schematic representation of a process chamber system suitable for carrying out an HF vapour etch of the MEMS of Figure 1;

Figure 3 presents a schematic representation of the MEMS of Figure 1 following the HF vapour etch process;

Figure 4 presents a flow chart of the methodology for producing a MEMS.

Figure 2 presents a schematic representation of an etching apparatus 6 suitable for etching the MEMS 1 of Figure 1. The etching apparatus 6 can be seen to comprise an etching chamber 7 attached to which are six input lines 8, 9, 10, 11, 12 and 13, and an output vacuum line 14.

Within the etching chamber 7 is a temperature controlled pedestal 15 suitable for locating the MEMS structure 1 to be etched within the etching chamber 7. Fluids supplied from the six input lines 8, 9, 10,11, 12 and 13 enter the internal volume of the etching chamber 7 via a fluid injection system 16 located within a lid 17 the etching chamber 7.

The pedestal 15, upon which the MEMS 1 is located, can be set and maintained at a pedestal temperature $T_p$, by a

temperature controller. This temperature may be above or below room temperature, the particular temperature being selected to optimise the etching process (typically 5 - 25°C). In addition, during the etching process the walls of the etching chamber 7 are heated, typically to around 20 - 70 °C.

The pressure of the etchant gas within the etching chamber, $P_c$, is monitored by a chamber pressure controller 18. The pressure controller 18 also incorporates a gas flow controller employed to provide a means of controlling the pressure within the etching chamber 7 by controlling the operation of a vacuum pumping system 19 located on the output vacuum line 14.

HF vapour 20 is controllably supplied to the etching chamber 7 by the first input line 8 through a regulator 21 and a first mass flow controller (MFC) 22.

Controlled quantities of water are supplied to the etching chamber 7 by the second input line 9. In particular, a liquid fluid controller (LFC) 23 and vaporiser 24 located within the second input line 9 is employed to produce controlled levels of water vapour from a water reservoir 25. A flow of nitrogen from a nitrogen gas source 26 through to the vaporiser 24 is controlled by a second MFC 22. The nitrogen carrier gas is employed to transport water vapour to the internal volume of etching chamber 7 via the fluid injection system 16.

The third 10, fourth 11 and fifth 12 input lines provide means for connecting additional gas sources 27, 28 and 29 e.g. hydrogen ($H_2$) or a hydrogen compound; oxygen ($O_2$) or a oxygen compound; or fluorine ($F_2$) or a fluorine compound; to the internal volume of the etching chamber 7. Control of these gas flows is again provided by mass flow controllers (MFC) 22.

Xenon Difluoride ($XeF_2$) vapour 30 is controllably supplied to the etching chamber 7 by the sixth input line 13 through a second regulator 21 and a mass flow controller (MFC) 22. The flow of the $XeF_2$ vapour 30 may also be controlled by a carrier gas flowing through a bubbler or container within which the $XeF_2$ is housed.

A computer controller 31 is employed to automate the regulation of the various components and parameters of the etching chamber 7, e.g. the supply of nitrogen carrier gas, HF vapour, chamber temperatures and pressure etc.

In order to allow the described method of etching to proceed it is necessary to obtain a diagnostic that allows for the accurate monitoring of the condensed fluid layer 5. As described above, the physical properties of the condensed fluid layer 5 directly affect the etching rate on the MEMS 1 thus by monitoring the etch rate a direct diagnostic of the physical properties of the condensed fluid layer 5 is obtained.

In practice the etch rate can be monitored in numerous ways, e.g. by monitoring the level of by-products produced, by monitoring the wafer etch directly or by monitoring a change in chamber conditions.

Figure 3 presents a schematic representation of the MEMS 1 of Figure 1 following the HF vapour etch process carried out within etching apparatus 6 of Figure 2. As can be seen, once the HF process is complete the silicon dioxide layer 2 is removed such that the silicon nitride ($Si_3N_4$) layer 3, is free of the substrate 4 and so can operate as required. Unfortunately, a solid residual layer, represented generally by reference numeral 32, is present on the exposed surfaces of the MEMS 1. The solid residual layer 32 has the appearance of a random distribution of particle residues.

Of the chemical precursors employed within the previously discussed PECVD processes to deposit the silicon nitride layer 3 the most commonly used silicon sources is silane ($SiH_4$).

Surprisingly, the applicants have found that the residual layer 32 produced during the HF vapour etch of the MEMS 1, instead of comprising the anticipated ammonium salts, often comprises a silicon impurity. The silicon impurity has been seen to be present irrespective of the silicon source employed in the deposition process of the silicon nitride ($Si_3N_4$) layer 3. The presence of the silicon impurity is however found to be increased within the residual layer 32 when the PECVD conditions are employed to produce a silicon rich silicon nitride ($Si_3N_4$) layer 3 highlighting that the source of the solid residual layer 32 is the HF vapour etching of the silicon nitride ($Si_3N_4$) layer 3. In these circumstances, when the HF vapour etches the silicon nitride ($Si_3N_4$) layer 3 it does not etch the silicon contaminant contained therein and thus the silicon contaminant remains as a solid residue. To date, a silicon based solid residual layer 32 has been completely overlooked in the art since the presence of silicon within any post etching analysis of the MEMS 1 has always been attributed by the skilled man to the fact that silicon is located within other areas of the device e.g. the substrate 4.

Various methods for producing a microstructure e.g. a semiconductor device or a MEMS 1, inclusive of removing the solid silicon residual layer 32, will now be described with reference to Figure 4.

The process involves the HF vapour etching of a sacrificial silicon dioxide layer 2, as described in detail above with respect to Figures 1 to 3. The process then involves removing the solid silicon residual layer 32 from the microstructure by employing one or more of the following techniques. As discussed above, a solid silicon residual layer 32 is formed by the HF vapour also etching the silicon nitride ($Si_3N_4$) layer 3 since the selectivity with the silicon dioxide ($SiO_2$) sacrificial layer 2 is never absolute.

As the residual layer 32 comprises silicon the third input line 10 may be employed to connect the hydrogen or hydrogen compound gas source 27 to the etching chamber 7. The hydrogen or hydrogen compound gas may be ionised, for example by a remote plasma system, before being supplied to the etching chamber 7. Alternatively, the hydrogen or hydrogen compound gas may be ionised within the etching chamber 7 itself. The silicon within the residual layer 32 then reacts with the hydrogen to produce silane ($SiH_4$). As silane ($SiH_4$) is a volatile substance it can simply be pumped out of the

etching chamber 7 by the vacuum pumping system 19.

Alternatively, the fourth input line 11 may be employed to connect the oxygen or oxygen compound gas source 28 to the etching chamber 7. The oxygen or oxygen compound gas may be ionised, for example by a remote plasma system, before being supplied to the etching chamber 7. Alternatively, the oxygen or oxygen compound gas may be ionised within the etching chamber 7 itself. The silicon within the residual layer 32 then reacts with the oxygen to produce silicon dioxide ($SiO_2$). The above described HF vapour etching process can then be repeated in order to remove the residual layer 32 in a similar manner to that describes with respect to the sacrificial silicon dioxide layer 2. The by-products of this second HF vapour etching process can again simply be pumped out of the etching chamber 7 by the vacuum pumping system 19.

In a further alternative embodiment, the fifth input line 12 may be employed to connect the fluorine or fluorine compound gas source 29 to the etching chamber 7. The fluorine or fluorine compound gas may be ionised, for example by a remote plasma system, before being supplied to the etching chamber 7. Alternatively, the fluorine or fluorine compound gas may be ionised within the etching chamber 7 itself. The silicon within the residual layer 32 then reacts with the fluorine to produce silicon tetrafluoride ($SiF_4$). As silicon tetrafluoride ($SiF_4$) is a volatile substance it can simply be pumped out of the etching chamber 7 by the vacuum pumping system 19.

A fourth technique that can be employed to remove the solid silicon residual layer 32 is to carry out a Xenon Difluoride ($XeF_2$) vapour etching process within the etching chamber 7. Here the sixth input line 13 is employed to connect the Xenon Difluoride ($XeF_2$) vapour 30 to the etching chamber 7. The applicants own European patent numbers EP 1,766,665 B1 and EP 2,480,493 B1 both disclose techniques for etching silicon with Xenon Difluoride ($XeF_2$) vapour which can be carried out by adapting the etching apparatus 6 of Figure 2.

It will be recognised that the above described methods for removing the solid silicon residual layer 32 could be problematic as there are normally other exposed areas of silicon material that forms the operating MEMS 1 or semiconductor device. Therefore, any of the above described techniques for removal of the silicon residual layer 32 would be expected to also remove silicon within these surrounding areas. However, the applicants have discovered that the rate of etching of the silicon residual layer 32 is generally much higher than for any silicon found within surrounding areas of the device. As a result, the above techniques can be carried out before any significant etching of the surrounding silicon areas takes place. The applicants believe that the reason for these significant differences in silicon etch rates is due to the fact that the silicon within the exposed solid residual layer 32 is not a well-structured solid but instead comprises a very amorphous porous structure.

When the residual layer 32 comprises anticipated ammonium salt, an alternative technique is required to be employed. As ammonium salt is known to decompose at temperatures >160 °C the applicants realised that by employing the heating elements within the etching chamber 7 to heat the MEMS 1 then the ammonium salt can be caused to evaporate and thereafter pumped out of the etching chamber 7 by the vacuum pumping system 19.

The above described methods of forming a MEMS comprising silicon nitride ($Si_3N_4$) have the significant advantage over those systems known in the art that employ an HF vapour etch step to remove a silicon dioxide ($SiO_2$) sacrificial layer in that they provide a means for reduction or removal of solid silicon residual layers formed as a by-product of the HF vapour also etching the silicon nitride ($Si_3N_4$). Most significantly, the above described methods provide a means for the removal of previously unrecognised silicon based residual layers.

Although the above described techniques have been described specifically with reference to MEMS the above techniques apply to alternative microstructures comprising silicon nitride ($Si_3N_4$) (e.g. semiconductor devices) the production of which employs an HF vapour etch step to remove a silicon dioxide ($SiO_2$) sacrificial layer.

The above described HF vapour etching, and the removal of the silicon residual layer, have been described as taking place within a common process chamber. It will be further appreciated by the skilled reader that an alternative embodiment would be to transfer the microstructures from a first process chamber, within which the HF vapour etch is preformed, to a second processing chamber in order to perform one or more of the above described techniques for the removal of the silicon residual layer.

There is provided a method of producing a microstructure comprising silicon nitride ($Si_3N_4$) the method comprising employing a hydrogen fluoride (HF) vapour to etch a sacrificial layer of silicon dioxide ($SiO_2$) and thereafter removing a residual layer formed when the HF vapour also etches the silicon nitride ($Si_3N_4$). The residual layer comprises silicon and various techniques are disclosed for removing such layers. These techniques may be applied concurrently, or sequentially, to the microstructure. The described methodologies therefore produce microstructures that exhibits reduced levels of silicon residue when as compared to those techniques known in the art.

The foregoing description has been presented for the purposes of illustration and explanation and is not intended to be exhaustive or to limit the invention to the precise form disclosed. The described embodiments were chosen and described in order to best explain the principles of the invention and its practical application to thereby enable others skilled in the art to best utilise the invention in various embodiments and with various modifications as are suited to the particular use contemplated. Therefore, further modifications or improvements may be incorporated without departing from the scope of the invention as defined by the appended claims.

## Claims

1. A method of producing a microstructure that comprises silicon rich silicon nitride ($Si_3N_4$) (3), the method comprising:

   - employing a hydrogen fluoride (HF) vapour (20) to etch a sacrificial layer of silicon dioxide ($SiO_2$) (2) wherein the HF vapour (20) also etches the silicon rich silicon nitride ($Si_3N_4$) (3);
   and **characterised by**
   - once the HF vapour etch is complete, subsequently removing a solid silicon residue (32) formed by the HF vapour etch.

2. A method of producing a microstructure that comprises silicon rich silicon nitride ($Si_3N_4$) (3) as claimed in claim 1, wherein the vapour etching of the sacrificial layer of silicon dioxide ($SiO_2$) (2) and the removal of the solid silicon residue (32) are performed sequentially within separate processing chambers .

3. A method of producing a microstructure that comprises silicon rich silicon nitride ($Si_3N_4$) (3) as claimed in claim 1 or claim 2, wherein removing the solid silicon residue (32) comprises reacting the solid silicon residue (32) with a first additional gas.

4. A method of producing a microstructure that comprises silicon rich silicon nitride ($Si_3N_4$) (3) as claimed in claim 1 or claim 2, wherein removing the solid silicon residue (32) comprises reacting the solid silicon residue (32) with a hydrogen or hydrogen compound gas (27) to produce silane ($SiH_4$).

5. A method of producing a microstructure that comprises silicon rich silicon nitride ($Si_3N_4$) (3) as claimed in claim 1 or claim 2, wherein removing the solid silicon residue (32) comprises reacting the solid silicon residue (32) with an oxygen or oxygen compound gas (28) to produce a silicon dioxide ($SiO_2$).

6. A method of producing a microstructure that comprises silicon rich silicon nitride ($Si_3N_4$) (3) as claimed in claim 5, wherein removing the solid silicon residue (32) further comprise employing a hydrogen fluoride (HF) vapour (20) to etch the silicon dioxide ($SiO_2$).

7. A method of producing a microstructure that comprises silicon rich silicon nitride ($Si_3N_4$) (3) as claimed in claim 1 or claim 2, wherein removing the solid silicon residue (32) comprises reacting the solid silicon residue (32) with a fluorine or fluorine compound gas (29) to produce silicon tetrafluoride ($SiF_4$).

8. A method of producing a microstructure that comprises silicon rich silicon nitride ($Si_3N_4$) (3) as claimed in claim 1 or claim 2, wherein removing the solid silicon residue (32) comprises etching the solid silicon residue (32) with a Xenon Difluoride ($XeF_2$) vapour (30).

9. A method of producing a microstructure that comprises silicon rich silicon nitride ($Si_3N_4$) (3) as claimed in any of the preceding claims, wherein the method further comprises employing a vacuum pumping system (19) to remove by products formed when removing the solid silicon residue (32).

10. A method of producing a microstructure that comprises silicon rich silicon nitride ($Si_3N_4$) (3) as claimed in any of the preceding claims, wherein the microstructure comprises a micro electromechanical systems (MEMS) (1).

11. A method of producing a microstructure that comprises silicon rich silicon nitride ($Si_3N_4$) (3) as claimed in any of the preceding claims, wherein the microstructure comprises a semiconductor device.

## Patentansprüche

1. Ein Verfahren zur Herstellung einer Mikrostruktur, die siliziumreiches Siliziumnitrid ($Si_3N_4$) (3) umfasst, wobei das Verfahren Folgendes umfasst:

   - Verwendung eines Fluorwasserstoff (HF)-Dampfes (20) zum Ätzen einer Opferschicht aus Siliziumdioxid ($SiO_2$) (2), wobei der HF-Dampf (20) auch das siliziumreiche Siliziumnitrid ($Si_3N_4$) (3) ätzt;
   und **gekennzeichnet durch**
   - nach Beendigung der HF-Dampfätzung Entfernen durch die HF-Dampfätzung gebildeten festen Siliziumrückstände (32).

2. Ein Verfahren zur Herstellung einer Mikrostruktur, die siliziumreiches Siliziumnitrid ($Si_3N_4$) (3) umfasst, nach Anspruch 1, wobei das Dampfätzen der Opferschicht aus Siliziumdioxid ($SiO_2$) (2) und das Entfernen des festen Siliziumrestes (32) nacheinander in getrennten Prozesskammern durchgeführt werden.

3. Ein Verfahren zur Herstellung einer Mikrostruktur, die siliziumreiches Siliziumnitrid ($Si_3N_4$) (3) umfasst, nach Anspruch 1 oder 2, wobei das Entfernen des festen Siliziumrückstands (32) die Reaktion des festen Siliziumrückstands (32) mit einem ersten zusätzlichen Gas umfasst.

4. Ein Verfahren zur Herstellung einer Mikrostruktur, die siliziumreiches Siliziumnitrid ($Si_3N_4$) (3) umfasst, nach Anspruch 1 oder 2, wobei das Entfernen des festen Siliziumrückstands (32) das Umsetzen des festen Siliziumrückstands (32) mit einem Wasserstoff oder Wasserstoffverbindungsgas (27) umfasst, um Silan ($SiH_4$ herzustellen.

5. Ein Verfahren zur Herstellung einer Mikrostruktur, die siliziumreiches Siliziumnitrid ($Si_3N_4$) (3) umfasst, nach Anspruch 1 oder 2, wobei das Entfernen des festen Siliziumrückstands (32) das Umsetzen des festen Siliziumrückstands (32) mit einem Sauerstoff- oder Sauerstoffverbindungsgas (28) umfasst, um ein Siliziumdioxid ($SiO_2$) herzustellen.

6. Ein Verfahren zur Herstellung einer Mikrostruktur, die siliziumreiches Siliziumnitrid ($Si_3N_4$) (3) umfasst, nach Anspruch 5, wobei das Entfernen des festen Siliziumrückstandes (32) zudem die Verwendung eines Fluorwasserstoff (HF)-Dampfes (20) umfasst, um das Siliziumdioxid ($SiO_2$) zu ätzen.

7. Ein Verfahren zur Herstellung einer Mikrostruktur, die siliziumreiches Siliziumnitrid ($Si_3N_4$) (3) umfasst, nach Anspruch 1 oder 2, wobei das Entfernen des festen Siliziumrückstands (32) das Umsetzen des festen Siliziumrückstands (32) mit einem Fluor- oder Fluorverbindungsgas (29) umfasst, um Siliziumtetrafluorid ($SiF_4$) herzustellen.

8. Ein Verfahren zur Herstellung einer Mikrostruktur, die siliziumreiches Siliziumnitrid ($Si_3N_4$) (3) umfasst, nach Anspruch 1 oder Anspruch 2, wobei das Entfernen des festen Siliziumrückstands (32) das Ätzen des festen Siliziumrückstands (32) mit einem Xenondifluorid ($XeF_2$)-Dampf (30) umfasst.

9. Ein Verfahren zur Herstellung einer Mikrostruktur, die siliziumreiches Siliziumnitrid ($Si_3N_4$) (3) umfasst, nach einem der vorhergehenden Ansprüche, wobei das Verfahren zudem die Verwendung eines Vakuumpumpsystems (19) umfasst, um Nebenprodukte zu entfernen, die beim Entfernen des festen Siliziumrückstands (32) entstehen.

10. Ein Verfahren zur Herstellung einer Mikrostruktur, die siliziumreiches Siliziumnitrid ($Si_3N_4$) (3) umfasst, nach einem der vorhergehenden Ansprüche, wobei die Mikrostruktur ein mikroelektromechanisches System (MEMS) (1) umfasst.

11. Ein Verfahren zur Herstellung einer Mikrostruktur, die siliziumreiches Siliziumnitrid ($Si_3N_4$) (3) umfasst, nach einem der vorhergehenden Ansprüche, wobei die Mikrostruktur eine Halbleitervorrichtung umfasst.

## Revendications

1. Un procédé de production d'une microstructure comprenant du nitrure de silicium riche en silicium ($Si_3N_4$) (3), le procédé consistant à :

   - utiliser de la vapeur de fluorure d'hydrogène (HF) (20) pour attaquer une couche sacrificielle de dioxyde de silicium ($SiO_2$) (2), la vapeur HF (20) attaquant également le nitrure de silicium riche en silicium ($Si_3N_4$) (3) ; et à
   - une fois l'attaque à la vapeur HF terminée, éliminer ensuite un résidu de silicium solide (32) formé par l'attaque à la vapeur HF.

2. Le procédé de production d'une microstructure comprenant du nitrure de silicium riche en silicium ($Si_3N_4$) (3) de la revendication 1, dans lequel l'attaque à la vapeur de la couche sacrificielle de dioxyde de silicium ($SiO_2$) (2) et l'élimination du résidu de silicium solide (32) sont effectuées de manière séquentielle dans des chambres de traitement distinctes.

3. Le procédé de production d'une microstructure comprenant du nitrure de silicium riche en silicium ($Si_3N_4$) (3) de la revendication 1 ou 2, dans lequel l'élimination du résidu de silicium solide (32) consiste à faire réagir le résidu de silicium solide (32) avec un premier gaz supplémentaire.

4. Le procédé de production d'une microstructure comprenant du nitrure de silicium riche en silicium ($Si_3N_4$) (3) de la revendication 1 ou 2, dans lequel l'élimination du résidu de silicium solide (32) consiste à faire réagir le résidu de silicium solide (32) avec de l'hydrogène gazeux ou un composé d'hydrogène gazeux (27) pour produire du silane ($SiH_4$).

5. Le procédé de production d'une microstructure comprenant du nitrure de silicium riche en silicium ($Si_3N_4$) (3) de la revendication 1 ou 2, dans lequel l'élimination du résidu de silicium solide (32) consiste à faire réagir le résidu de silicium solide (32) avec de l'oxygène gazeux ou un composé d'oxygène gazeux (28) pour produire du dioxyde de silicium ($SiO_2$).

6. Le procédé de production d'une microstructure comprenant du nitrure de silicium riche en silicium ($Si_3N_4$) (3) de la revendication 5, dans lequel l'élimination du résidu de silicium solide (32) consiste en outre à utiliser de la vapeur de fluorure d'hydrogène (HF) (20) pour attaquer le dioxyde de silicium ($SiO_2$).

7. Le procédé de production d'une microstructure comprenant du nitrure de silicium riche en silicium ($Si_3N_4$) (3) de la revendication 1 ou 2, dans lequel l'élimination du résidu de silicium solide (32) consiste à faire réagir le résidu de silicium solide (32) avec du fluor gazeux ou un composé de fluor gazeux (29) pour produire du tétrafluorure de silicium ($SiF_4$).

8. Le procédé de production d'une microstructure comprenant du nitrure de silicium riche en silicium ($Si_3N_4$) (3) de la revendication 1 ou 2, dans lequel l'élimination du résidu de silicium solide (32) consiste à attaquer le résidu de silicium solide (32) avec de la vapeur de difluorure de xénon ($XeF_2$) (30).

9. Le procédé de production d'une microstructure comprenant du nitrure de silicium riche en silicium ($Si_3N_4$) (3) de l'une des revendications précédentes, dans lequel le procédé consiste en outre à utiliser un système de pompage à vide (19) pour éliminer les sous-produits formés lors de l'élimination du résidu de silicium solide (32).

10. Le procédé de production d'une microstructure comprenant du nitrure de silicium riche en silicium ($Si_3N_4$) (3) de l'une des revendications précédentes, dans lequel la microstructure comprend un système micro-électromécanique (MEMS) (1).

11. Le procédé de production d'une microstructure comprenant du nitrure de silicium riche en silicium ($Si_3N_4$) (3) de l'une des revendications précédentes, dans lequel la microstructure comprend un dispositif semi-conducteur.

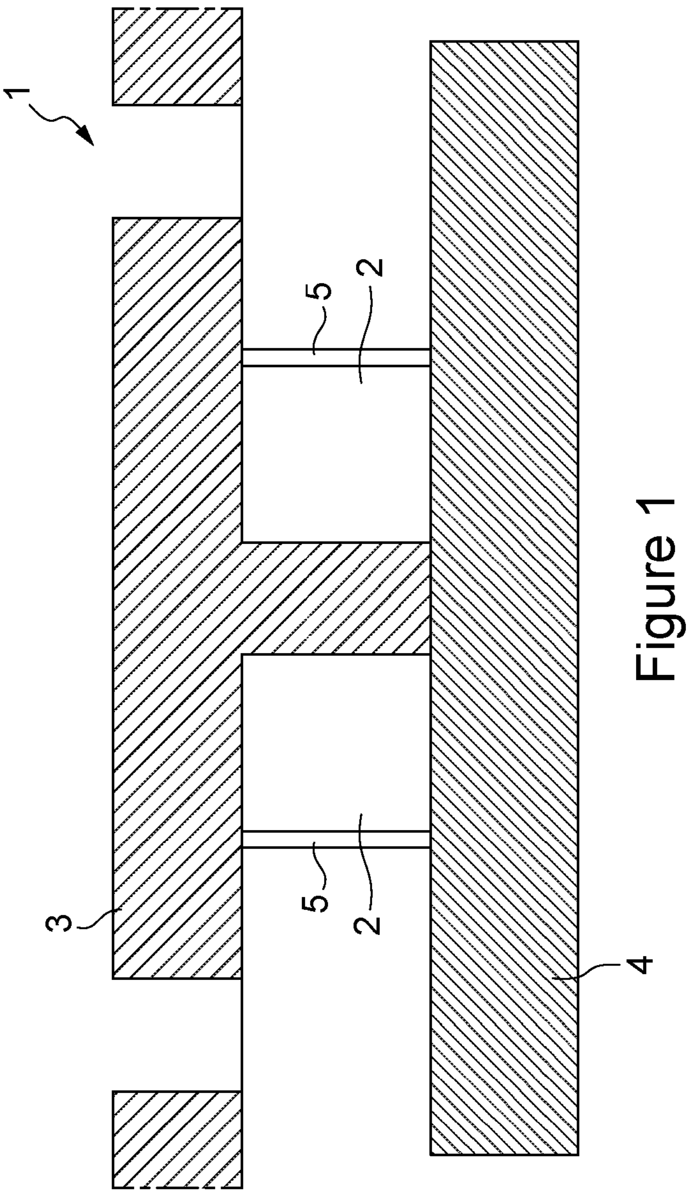


Figure 1
(Prior Art)

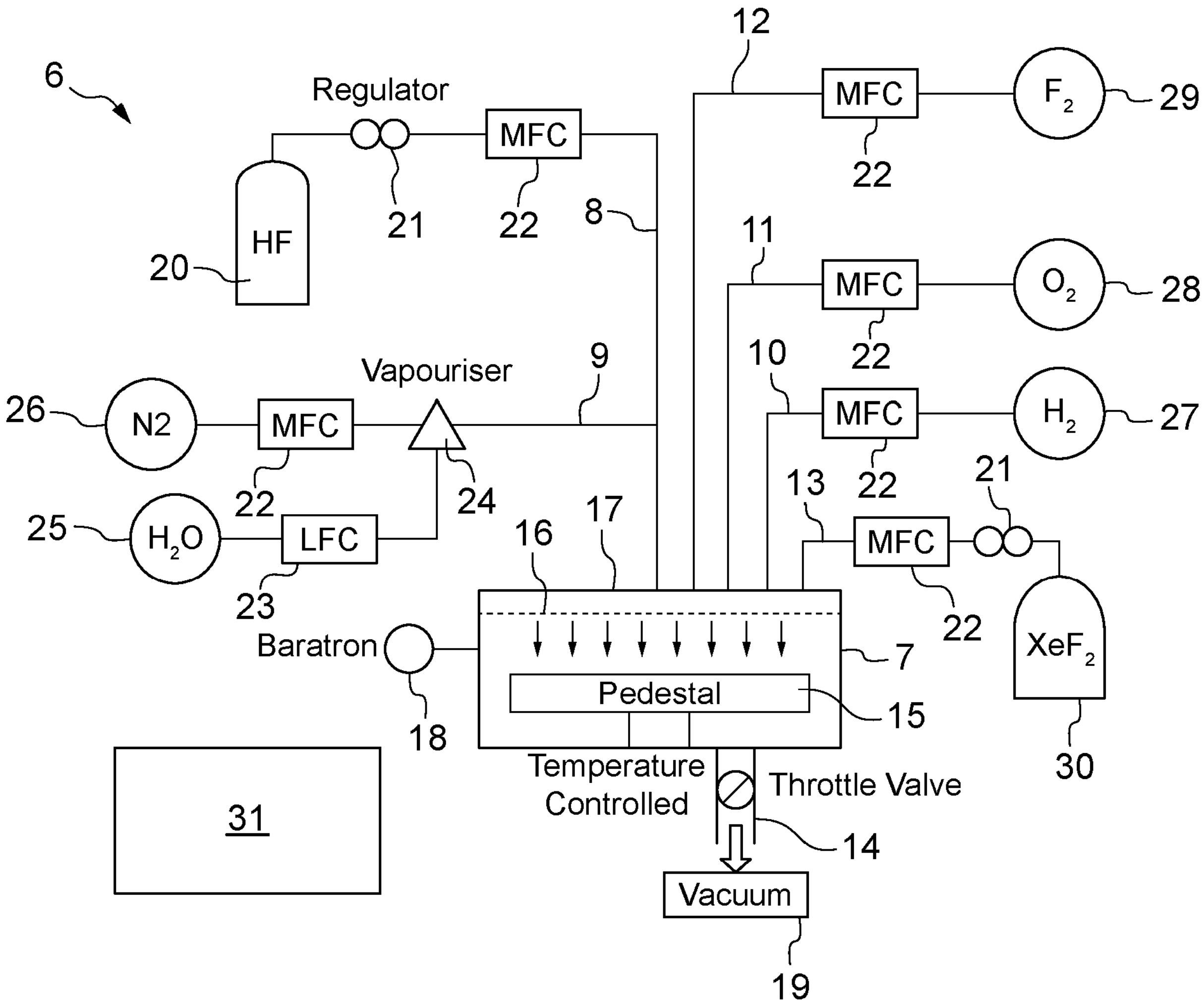
6
Regulator
MFC
HF
20
21
22
8
12
MFC
F2
29
22
11
MFC
O2
28
22
10
MFC
H2
27
13
22
21
MFC
22
XeF2
30
9
Vapouriser
26
N2
MFC
22
24
25
H2O
LFC
23
16
17
Baratron
18
7
Pedestal
15
Temperature Controlled
Throttle Valve
14
Vacuum
19
31

Figure 2

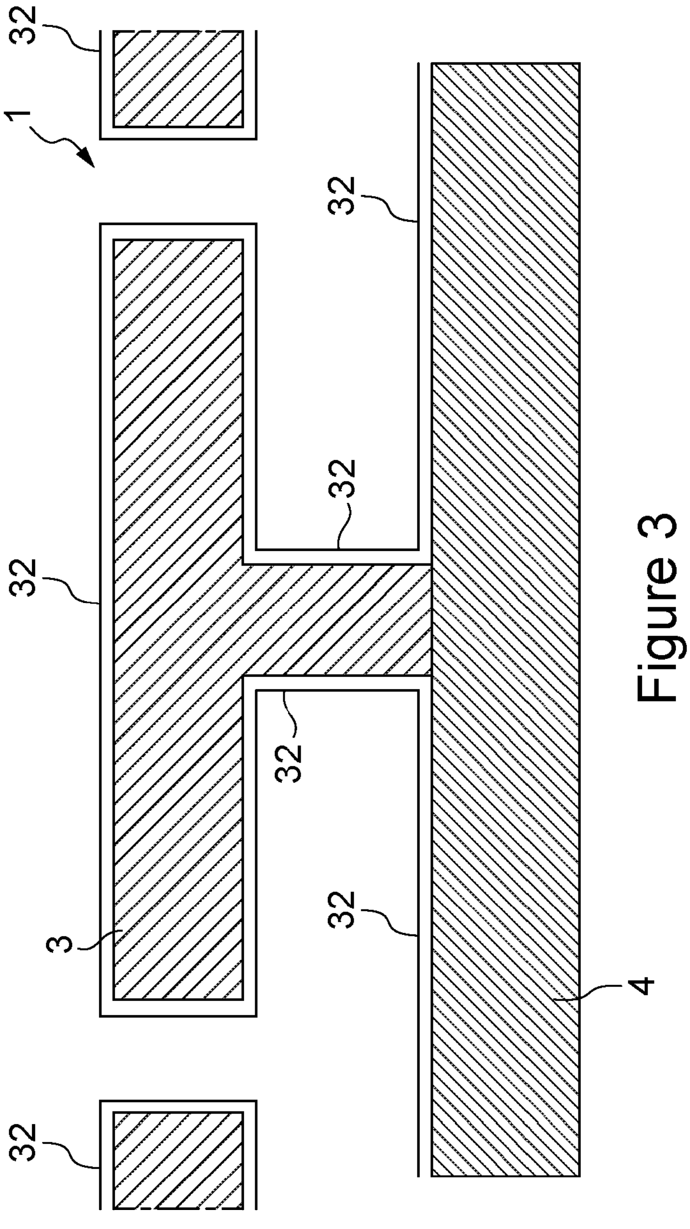


Figure 3

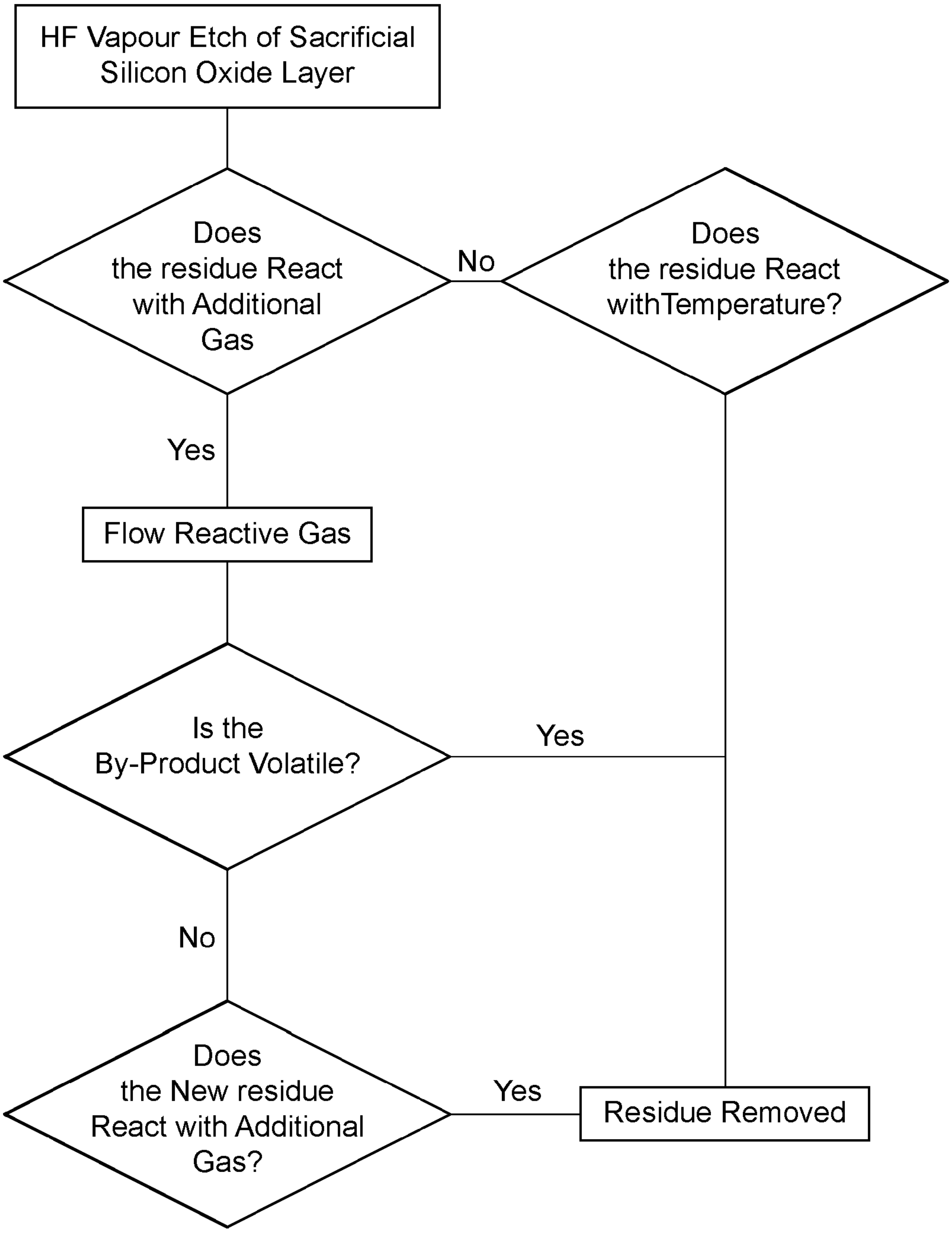
HF Vapour Etch of Sacrificial Silicon Oxide Layer
Does the residue React with Additional Gas
No
Does the residue React withTemperature?
Yes
Flow Reactive Gas
Is the By-Product Volatile?
Yes
No
Does the New residue React with Additional Gas?
Yes
Residue Removed

Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- GB 2487716 B
- US 7211496 B
- EP 2046677 B1
- US 20120107992 A1
- EP 1766665 B1
- EP 2480493 B1

### Non-patent literature cited in the description


- **HELMS**. Mechanisms of the HF/H2O vapor phase etching of SiO. *Journal of Vacuum Science and Technology A*, July 1992, vol. 10 (4)